# EUROPEAN PATENT SPECIFICATION

(11) **EP 2 693 202 B1**
(45) Date of publication and mention of the grant of the patent: **15.11.2017**
(21) Application number: 12764916.8
(22) Date of filing: 26.03.2012
(51) Int. Cl.: G01N 21/65, C03C 17/09, C23C 14/18, C23C 14/58, C23C 28/00, B82Y 15/00, B82Y 20/00, B82Y 40/00

(54) **MANUFACTURING METHOD FOR OPTICAL-ELECTRIC-FIELD ENHANCEMENT DEVICE**
HERSTELLUNGSVERFAHREN FÜR EINE VORRICHTUNG ZUR VERSTÄRKUNG EINES OPTISCH-ELEKTRISCHEN FELDES
PROCÉDÉ DE FABRICATION D'UN DISPOSITIF DESTINÉ À AMÉLIORER UN CHAMP OPTOÉLECTRIQUE

(30) Priority: 31.03.2011 JP 2011077868
(43) Date of publication of application: 05.02.2014
(73) Proprietor: Fujifilm Corporation, Minato-ku Tokyo 106-8620 (JP)
(72) Inventor: YAMAZOE, Shogo, Ashigarakami-gun Kanagawa 258-8577 (JP); NAYA, Masayuki, Ashigarakami-gun Kanagawa 258-8577 (JP)
(74) Representative: Hoffmann Eitle
(86) International application number: PCT/JP2012/002072
(87) International publication number: WO 2012/132385

(56) References cited:
- EP-A1- 2 618 133
- EP-A1- 2 618 134
- JP-A- H09 202 649
- JP-A- 2007 240 361
- JP-A- 2009 109 395
- JP-A- 2009 109 395
- JP-A- 2009 236 830
- JP-A- 2012 063 293
- JP-A- 2012 063 294
- JP-A- 2012 132 743
- JP-B2- 61 048 124
- JUNG-YEN YANG ET AL: "Surface-Enhanced Raman Scattering Active Substrates", IEEE NANOTECHNOLOGY MAGAZINE, IEEE, USA, vol. 5, no. 1, 1 March 2011 (2011-03-01), pages 12-16, XP011348529, ISSN: 1932-4510, DOI: 10.1109/MNANO.2010.939833
- JUNG-YEN YANG ET AL: "Detection of Staphylococcus aureus using hydrothermally roughened substrates", 2009 IEEE INTERNATIONAL CONFERENCE ON NANO/MOLECULAR MEDICINE AND ENGINEERING : NANOMED ; 18-21 OCT. 2009, TAINAN, IEEE, XX, 18 October 2009 (2009-10-18), pages 210-214, XP031740300, ISBN: 978-1-4244-5528-7
- CHENG H W ET AL: "Investigation of Raman enhancement in hydrothermally roughened SERS-active substrates", COMPUTER PHYSICS COMMUNICATION, ELSEVIER SCIENCE PUBLISHERS B.V., AMSTERDAM, NL, vol. 182, no. 1, 1 January 2011 (2011-01-01), pages 260-262, XP027477475, ISSN: 0010-4655, DOI: 10.1016/J.CPC.2010.07.025 [retrieved on 2010-11-04]
- "Sputter deposition", Wikipedia, 9 February 2011 (2011-02-09), pages 1-6, XP055131826, Retrieved from the Internet: URL:http://en.wikipedia.org/w/index.php?ti tle=Sputter_deposition&oldid=413009007 [retrieved on 2014-07-28]
- STEPAN A. ZYNIO ET AL: "Bimetallic Layers Increase Sensitivity of Affinity Sensors Based on Surface Plasmon Resonance", SENSORS, vol. 2, no. 2, 23 February 2002 (2002-02-23), pages 62-70, XP055132203, DOI: 10.3390/s20200062
- Seung Ho Choi ET AL: "Investigation on an application of silver substrates for sensitive surface plasmon resonance imaging detection", Journal of the Optical Society of America. A, Optics, image science, and vision, 1 October 2010 (2010-10-01), page 2229, XP055132205, United States DOI: 10.1364/JOSAA.27.002229 Retrieved from the Internet: URL:http://www.ncbi.nlm.nih.gov/pubmed/209 22013
- JUNG-YEN YANG ET AL.: 'Surface-Enhanced Raman Scattering Active Substrates' IEEE NANOTECHNOLOGY MAGAZINE vol. 5, no. 1, 24 February 2011, pages 12 - 16, XP011348529
- JUNG-YEN YANG ET AL.: 'Detection of Staphylococcus Aureus Using Hydrothermally Roughened Substrates' PROCEEDINGS OF THE 2009 IEEE 3RD INTERNATIONAL CONFERENCE ON NANO/MOLECULAR MEDICINE AND ENGINEERING 18 October 2009, pages 210 - 214, XP031740300

## Description

### Technical Field

The present invention is related to a method for producing an optical electrical field enhancing device equipped with a metal structure of fine protrusions and recesses capable of inducing localized Plasmon.

### Background Art

Sensor devices that utilize the electrical field enhancing effect due to localized plasmon on the surfaces of metals and electrical field enhancing devices of Raman spectroscopic devices are known. Raman spectroscopy is a technique that obtains the spectrum of Raman scattered light (Raman spectrum) by spectrally analyzing scattered light obtained by irradiating a substance with a single wavelength light beam, and is utilized to identify substances.

There is a Raman spectroscopy technique called SERS (Surface Enhanced Raman Scattering) that utilizes an optical electrical field enhanced by localized plasmon resonance in order to amplify weak Raman scattered light (refer to Non Patent Document 1). SERS utilizes the principle that when light is irradiated onto a metal body, particularly a metal body having nano order protrusions and recesses on the surface thereof, while the metal body is in contact with a substance, optical electrical field enhancement occurs due to localized plasmon resonance, and the intensity of Raman scattered light of a sample in contact with the surface of the metal body is amplified. Surface enhanced Raman scattering can be executed by employing a substrate having a metal structure of protrusions and recesses on the surface thereof as a carrier (substrate) that holds test subjects.

Si substrates, on the surface of which protrusions and recesses are provided, having metal films formed on the surface having the protrusions and recesses, are mainly employed as substrates having metal structures of protrusions and recesses on the surfaces thereof (refer to Patent Documents 1 through 3).

In addition, an Al substrate, the surface of which is anodized such that a portion thereof becomes a metal oxide layer (Al₂O₃) and a plurality of fine pores which are formed naturally within the metal oxide layer during the anodizing process are filled with metal, has also been proposed (refer to Patent Document 4).

### [Related Art Documents]

### [Patent Documents]

[Patent Document 1] PCT Japanese Phase Publication No. 2006-514286
[Patent Document 2] Japanese Patent No. 4347801
[Patent Document 3] Japanese Unexamined Patent Publication No. 2006-145230
[Patent Document 4] Japanese Unexamined Patent Publication No. 2005-172569

### [Non Patent Documents]

[Non Patent Document 1] Optics Express, Vol. 17, No. 21, pp. 18556

IEEE Nanotechnology Magazine, vol. 5, no. 1, 1 March 2011, pages 12-16; 2009 IEEE International Conference on Nano/Molecular Medicine and Engineering, 18-21 October 2009, pages 210-214; and Computer Physics Communication, vol. 182, no. 1, 1 January 2011, pages 260-262 all disclose methods for producing an optical electrical field enhancing device comprising forming a thin film of a first metal, such as titanium, on a substrate, such as a silicon wafer; forming a structure layer of fine protrusions and recesses formed of the first metal or its oxide by causing the thin film to undergo a hydrothermal reaction, and forming a metal structure layer of fine protrusions and recesses from a second metal on the surface of the structure layer of fine protrusions and recesses.

### Disclosure of the Invention

The metal structure of fine protrusions and recesses producing method is complex and it is difficult to form metal structures of fine protrusions and recesses having large areas in the inventions of Patent Documents 1 through 3 that employ photolithography and etching to form the structures of fine protrusions and recesses and the invention of Patent Document 4 that employs anodic oxidation to form the structures of fine protrusions and recesses. Therefore, it is considered that the cost of substrates per unit area is high. In addition, it is extremely difficult to form the aforementioned metal structures of fine protrusions and recesses on complex substrates such as liquid containers constituted by a plurality of protrusions and recesses.

The present invention has been developed in view of the foregoing circumstances. It is an object of the present invention to provide method for producing an optical electrical field enhancing device on substrates having arbitrary shapes, over comparatively large areas, and at low cost.

According to the present invention, there is provided a method for producing an optical electrical field enhancing device comprising:
forming a thin film from aluminium or alumina on a substrate;
forming a structure layer of fine protrusions and recesses having an average pitch and an average depth which are less than the wavelength of excitation light from bayerite and/or boehmite by causing the thin aluminium or alumina film to undergo a hydrothermal reaction, the pitch being the distance among the peaks of adjacent protrusions having recesses therebetween, and the depth being the distance from the peaks of the protrusions to the bottoms of the recesses adjacent thereto;
forming a metal structure layer of fine protrusions and recesses constituted by a second metal on the surface of the structure layer of fine protrusions and recesses by vapour deposition, the second metal being capable of generating localized plasmon when irradiated with excitation light,
the metal structure layer being such that at least one of the height of the protrusions in the direction perpendicular to the substrate and the length of the protrusions in the direction parallel to the substrate is less than the wavelength of excitation light; and
laminating either a dielectric or a third metal different from the second metal on the metal structure layer.

Preferably the metal structure layer has a different shape from the structure layer.

Preferably the second metal is gold, silver, copper, aluminium or platinum. In this case, it is more preferred that the second metal is gold and the thickness of the film formed by vapour deposition is 30 nm or greater. Alternatively, the second metal is preferably silver and the thickness of the film formed by vapour deposition is 150 nm or less.

The method for producing an optical electrical field enhancing device of the present invention enables an optical electrical field enhancing device to be obtained with a metal structure layer of fine protrusions and recesses having sizes of the order of several tens of nanometers by the simple steps of: the thin film forming step that forms a thin film formed from aluminium (hereafter sometimes referred to as the first metal) or alumina on a substrate; the structure layer of fine protrusions and recesses forming step that forms a structure layer of fine protrusions and recesses from bayerite and/or boehmite, by causing the thin aluminium or alumina film formed on the substrate to undergo a hydrothermal reaction; and the metal layer forming step that forms the metal structure layer of fine protrusions and recesses constituted by a second metal on the surface of the structure layer of fine protrusions and recesses.

Because an optical electrical field enhancing device can be obtained by these extremely simple steps, manufacturing costs can be greatly reduced compared to those of conventional devices.

In addition, each of the steps can be applied to substrates having comparatively large areas and substrates having arbitrary shapes. Therefore, it is possible to produce optical electrical field enhancing devices having large areas and optical electrical field enhancing devices having desired shapes.

An optical electrical field enhancing device obtained by the production method of the present invention is capable of effectively inducing localized plasmon at the surface of the metal structure of fine protrusions and recesses when light is irradiated onto the fine metal protrusions and recesses on the surface thereof. The localized plasmon generates an optical electrical field enhancing effect. In addition, light generated by a test subject placed on the optical electrical field enhancing device when light is irradiated onto the region at which the test subject is placed will be amplified by the optical electrical field enhancing effect, and it becomes possible to detect the generated light at high sensitivity. The optical electrical field enhancing device can be favorably employed as a surface enhanced Raman substrate that effectively amplifies Raman signals, to achieve improvements in detection sensitivity.

### Brief Description of the Drawings

Figure 1 is a collection of sectional diagrams that illustrate the steps of a method for producing an optical electrical field enhancing substrate.
Figure 2A is a perspective view of an electrical field enhancing substrate 1, which is a first embodiment of the optical electrical field enhancing device of the present invention.
Figure 2B is a magnified view of a portion IIB of a lower portion of the side surface of the optical electrical field enhancing substrate 1 illustrated in Figure 2A.
Figure 3 is a SEM image of the surface of a boehmite layer.
Figure 4A is a SEM image of the surface of a (30nm thick) vapor deposited gold layer.
Figure 4B is a SEM image of the surface of a (60nm thick) vapor deposited gold layer.
Figure 4C is a SEM image of the surface of a (90nm thick) vapor deposited gold layer.
Figure 4D is a SEM image of the surface of a (150nm thick) vapor deposited gold layer.
Figure 4E is a SEM image of the surface of a (250nm thick) vapor deposited gold layer.
Figure 4F is a SEM image of the surface of a (400nm thick) vapor deposited gold layer.
Figure 5A is a SEM image of the surface of a (30nm thick) vapor deposited silver layer.
Figure 5B is a SEM image of the surface of a (60nm thick) vapor deposited silver layer.
Figure 5C is a SEM image of the surface of a (90nm thick) vapor deposited silver layer.
Figure 5D is a SEM image of the surface of a (150nm thick) vapor deposited silver layer.
Figure 5E is a SEM image of the surface of a (250nm thick) vapor deposited silver layer.
Figure 5F is a SEM image of the surface of a (400nm thick) vapor deposited silver layer.
Figure 6 is a graph that illustrates a Raman spectrum distribution obtained for a sample having a vapor deposited gold film (60nm thick).
Figure 7 is a graph that illustrates a Raman spectrum distribution obtained for a sample having a vapor deposited silver film (60nm thick).
Figure 8 is a graph that illustrates the film thickness dependent properties of Raman signal intensities obtained for samples having vapor deposited gold films.
Figure 9 is a graph that illustrates the film thickness dependent properties of Raman signal intensities obtained for samples having vapor deposited silver films.

Best Mode for Carrying out the Invention Hereinafter, an embodiment of a method for producing an optical electrical field enhancing device of the present invention will be described with reference to the attached drawings.

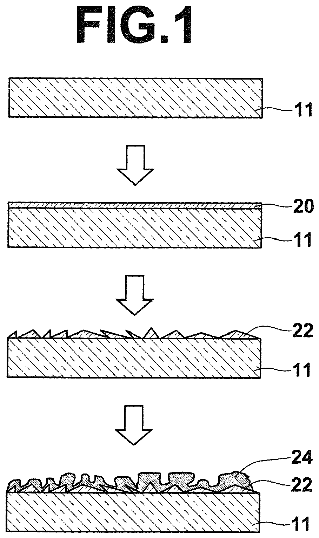

Figure 1 illustrates a method for producing an optical electrical field enhancing substrate, to form an optical electrical field enhancing device, and is a collection of sectional diagrams that illustrate each step of the method.

A plank shaped transparent substrate main body 11 is prepared. The transparent substrate main body 11 is cleansed with acetone and methanol. Thereafter, aluminum is employed as a first metal, and an aluminum film 20 is formed on the surface of the transparent substrate main body 11 at a thickness of approximately several tens of nanometers by the sputtering method as a thin film forming step.

Next, the transparent substrate main body 11 having the aluminum film 20 thereon is immersed in boiling pure water then taken out after several minutes (approximately 5 minutes) as a structure layer of fine protrusions and recesses forming step. The boiling treatment (hydrothermal reaction) renders the aluminum film 20 transparent, and produces a transparent structure layer of fine protrusions and recesses 22 formed by bayerite or boehmite.

Next, a second metal is vapor deposited onto the structure layer of fine protrusions and recesses 22, as a metal layer forming step.

A plank shaped substrate was employed in the example described above. However, the steps of the method may be applied to substrates of any desired shape.

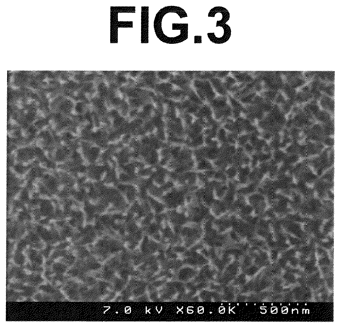

Aluminum is an example of the first metal that undergoes the hydrothermal reaction in the structure layer of fine protrusions and recesses forming step. Alternatively, a metal oxide such as alumina (Al(OH)₃) may be employed. A structure of fine protrusions and recesses having complex triangular pyramid structures (refer to Figure 3) formed of either or both of bayerite (Al[OH]₃) and boehmite (AlOOH) can be formed, by aluminum or alumina undergoing the hydrothermal reaction.

In addition, the method for forming the thin film from aluminium or alumina onto the substrate 11 is not limited to the sputtering method. The film may alternatively be formed by the heated vapor deposition method or by the sol gel method.

The hydrothermal reaction is not limited to the boiling process. As an alternative process, the substrate on which the film of the first metal has been formed may be exposed to high temperature steam, to cause the first metal to react with the high temperature steam.

The second metal that constitutes the metal structure layer of fine protrusions and recesses 24 may be any metal that generates localized plasmon when irradiated with excitation light. Examples of such metals include: gold (Au), silver (Ag), copper (Cu), aluminum (Al), platinum (Pt), and alloys having these metals as their main components. Au and Ag are particularly preferable.

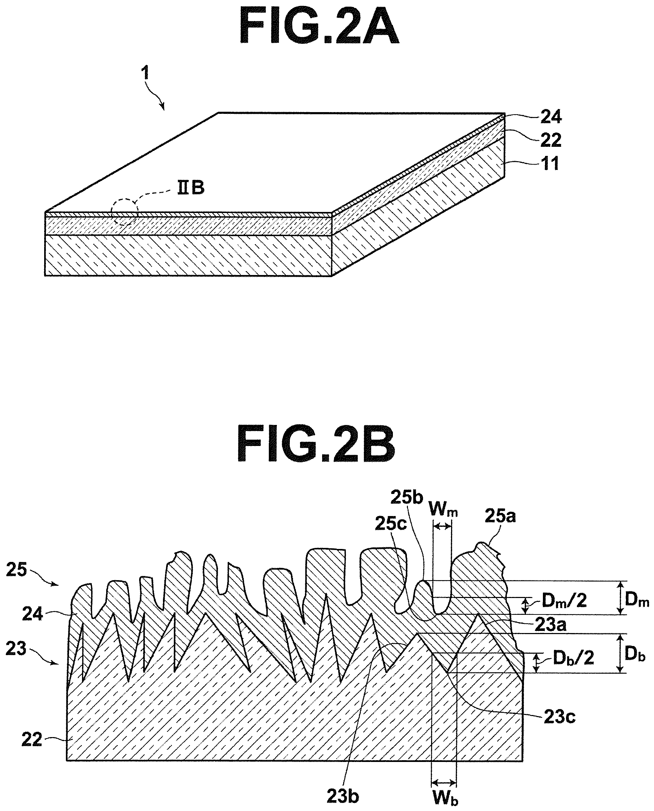

Figure 2A is a perspective view that illustrates the optical electrical field enhancing substrate 1. Figure 2B is a magnified view of a portion IIB of the side surface of the optical electrical field enhancing substrate 1 illustrated in Figure 2A.

As illustrated in Figure 2A and Figure 2B, the optical electrical field enhancing substrate 1 is constituted by the substrate 11, the structure layer of fine protrusions and recesses 22 having the structure of fine protrusions and recesses 23 on the surface thereof provided on the substrate 11, and the metal structure layer of fine protrusions and recesses 24 (metal layer) formed on the surface of the structure of fine protrusions and recesses 23. Localized plasmon resonance is induced by light (hereinafter, excitation light) irradiated onto a structure of fine protrusions and recesses 25 of the metal structure layer of fine protrusions and recesses 24, and an enhanced optical electrical field is generated on the surface of the metal structure layer of fine protrusions and recesses 24 by the localized plasmon resonance.

The transparent structure of fine protrusions and recesses 23 formed by boehmite has an overall saw toothed cross section, although the sizes (the sizes of the peak angles) and orientations of the protrusions vary. The transparent structure of fine protrusions and recesses 23 is that on which the metal structure layer of fine protrusions and recesses 24 can be formed, and has an average pitch and an average depth which are less than the wavelength of the excitation light. Note that here, the pitch of the transparent structure of fine protrusions and recesses 23 is the distance among the peaks of adjacent protrusions having recesses therebetween, and the depth is the distance from the peaks of the protrusions to the bottoms of the recesses adjacent thereto.

Note that in the case that a transparent substrate such as a glass substrate is employed as the substrate 11, and a transparent structure layer of fine protrusions and recesses 22 formed by a bayerite layer or a boehmite layer is formed, excitation light can be caused to enter from either the front surface or the back surface of the substrate to generate the optical electrical enhancing field at the surface of the metal layer 24. In addition, signal light such as Raman signal light can also be detected from either the front surface or the back surface of the substrate. Here, the term transparent refers to a transmissivity of 50% or greater with respect to irradiated light and with respect to light generated by a test subject due to the irradiated light. Note that it is more preferable for the transmissivity with respect to these types of light to be 75% or greater, and even more preferably, 90% or greater.

The metal structure layer of fine protrusions and recesses 24 is formed along the surface of the structure layer of fine protrusions and recesses 22, and may have substantially the same structure of fine protrusions and recesses as the structure of fine protrusions and recesses 23. Alternatively, the structure of fine protrusions and recesses 25 of the metal structure layer of fine protrusions and recesses 24 may have protrusions and recesses of shapes different from the structure of fine protrusions and recesses 23 of the structure layer of fine protrusions and recesses 22, as illustrated in Figure 2B.

If the thickness of vapor deposited metal is thin in the production method described above, the structure of fine protrusions and recesses of the metal layer will have substantially the same structure of fine protrusions and recesses as the structure of fine protrusions and recesses 23 of the structure layer of fine protrusions and recesses 22. If the thickness of vapor deposited metal is thick, the metal structure layer of fine protrusions and recesses 24 will have a structure of fine protrusions and recesses in which the distances among adjacent protrusions is less than the distances among corresponding protrusions of the structure of fine protrusions and recesses 23, as illustrated in Figure 2B. Protrusions 24a of the metal structure layer of fine protrusions and recesses 24 are rounded, and the distances among adjacent protrusions are smaller compared to a case in which a metal film is formed along the structure of fine protrusions and recesses 23 of the structure layer of fine protrusions and recesses 22.

It is preferable for portions at which the distance Wm between a protrusion 25a and an adjacent protrusion 25b in the structure of fine protrusions and recesses 25 of the metal structure layer of fine protrusions and recesses 24 is less than the distance Wb between a protrusion 23a and a protrusion 23b of the structure of fine protrusions and recesses 23 of the substrate corresponding to the protrusions 25a and 25b to be present, as illustrated in Figure 2B. Here, the distance Wm between the adjacent protrusions 25a and 25b is defined as the distance from the peak of the lower protrusion 25b to a position of the protrusion 25a having half the depth Dm/2 of the depth Dm of the deepest portion of a recess 25c between the adjacent protrusions 25a and 25b. Similarly, the distance Wb between the adjacent protrusions 23a and 23b is defined as the distance from the peak of the lower protrusion 23b to a position of the protrusion 23a having half the depth Db/2 of the depth Db of the deepest portion of a recess 23c between the adjacent protrusions 23a and 23b.

The structure of fine protrusions and recesses 25 of the metal structure layer of fine protrusions and recesses 24 is a structure of fine protrusions and recesses in which at least one of the length of the protrusions in the direction perpendicular to the substrate and the length of the protrusions in the direction parallel to the substrate is less than the wavelength of excitation light, such that localized plasmon can be generated on the surface of the metal structure layer of fine protrusions and recesses 24.

It is desirable for the protrusions of the metal structure layer of fine protrusions and recesses 24 to be granules formed by agglomeration of metal. It is desirable for the aspect ratio (length in the direction perpendicular to the substrate/length in the direction parallel to the substrate) of the granular protrusions to be 0.5 or greater.

Note that it is desirable for the average depth from the peaks of the protrusions to the bottoms of recesses adjacent thereto to be 200nm or less, and for the average pitch among the peaks of adjacent protrusions having recesses therebetween to be 200nm or less in the structure of fine protrusions and recesses 25 of the metal structure layer of fine protrusions and recesses 24.

It is preferable for the thickness of the metal structure layer of fine protrusions and recesses formed on the structure of fine protrusions and recesses of the substrate to be 400 nm or less in the case that gold is used as the metal and for the thickness to be 90 nm or less in the case that silver is used as the metal. A metal structure of fine protrusions and recesses capable of generating an efficiently enhanced optical electrical field can be obtained, by vapor depositing amounts of gold or silver corresponding to these thicknesses.

Note that it is not necessary for the distances among all adjacent protrusions in the structure of fine protrusions and recesses of the metal structure layer of fine protrusions and recesses to be less than the distances among corresponding adjacent protrusions in the structure of fine protrusions and recesses of the substrate. However, the optical electrical field enhancing effect will become more significant as the number of adjacent protrusions of the metal structure layer of fine protrusions and recesses having distances less than the distances of corresponding adjacent protrusions in the structure of fine protrusions and recesses of the substrate increases.

Particularly, if there are regions at which the distances among adjacent protrusions of the metal structure layer of fine protrusions and recesses 25 are 20nm or less, extremely intense optical electrical field enhancing fields, called hot spots, can be generated at such regions. For this reason, it is preferable for a great number of locations at which the distance between adjacent protrusions is 20nm or less to be present. According to the invention, either a dielectric or a third metal different from the second metal is then laminated on the metal structure layer (24). Interference effects and oxidization preventing effects can be imparted by laminating two or more types of metals or by laminating a dielectric on the second metal. That is, light will be trapped within the structure layer if the thickness of the structure layer matches a certain phase of the light by the optical interference effect, and a more intense optical electrical field enhancing effect can be generated. In addition, the oxidization of silver can be suppressed by providing a silver layer as the second metal, and by laminating gold on the silver layer.

Note that in the case that a dielectric is to be laminated on the metal structure layer of fine protrusions and recesses formed by the second metal, it is desirable for the thickness of the dielectric to be 50nm or less. SiO₂ may be laminated at a thickness of 10nm on the metal structure layer of fine protrusions and recesses, for example.

### [Examples]

Hereinafter, concrete production examples of the optical electrical field enhancing substrate 1, and the results of Raman spectrum measurement employing measurement samples, will be described.

### [Method for Producing Optical Electrical Field Enhancing Substrate]

A glass substrate (BK-7: Eagle 2000 by Corning) was employed as the transparent substrate main body 11.

The glass substrate main body 11 underwent ultrasonic cleansing (45kHz) with acetone for 5 minutes and with methanol for 5 minutes. Then, a 25nm thick layer of aluminum 20 was formed on the glass substrate 11 using a sputtering apparatus (by Canon Anelva) . Note that a surface shape measuring device (by TENCOR) was employed to measure the thickness of the aluminum layer, and the thickness was confirmed to be 25nm (±10%).

Thereafter, pure water was prepared in a water bath (by Nishi Seiki K. K.) and boiled. The glass substrate main body 11 having the aluminum layer 20 thereon was immersed in the boiling water, then removed after 5 minutes had passed. At this time, it was confirmed that the aluminum became transparent 1 to 2 minutes after the glass substrate 11 having the aluminum layer 20 thereon was immersed in the boiling water. This is because the aluminum layer 20 became the structure layer of fine protrusions and recesses 22 formed by boehmite or bayerite by the boiling treatment.

Figure 3 illustrates the results of observing the surface of the boehmite layer 22 with a SEM (S4100 by Hitachi). The white portions of Figure 3 are protrusions, and the gray portions are recesses. The patterns of protrusions and recesses are irregular, but are formed across the entirety of the surfaces of the boehmite layer, and the in plane uniformity of the structure of fine protrusions and recesses is high. It can be understood that the structure of protrusions and recesses is constituted by a great number of peak shaped protrusions from the photograph of the surface of the boehmite layer illustrated in Figure 3. Note that the cross section of the structure of protrusions and recesses of the boehmite layer is saw toothed as schematically illustrated in Figure 2B.

Finally, 30nm worth of Au was vapor deposited onto the surface of the boehmite layer 22 by EB (Electric Beam) vapor deposition, to produce a sample with a metal structure layer of fine protrusions and recesses 24. Note that samples in which 60nm, 90nm, 150nm, 250nm, and 400nm worth of Au were deposited on the surface of the transparent structure layer of fine protrusions and recesses 22, as well as samples in which 60nm, 90nm, 150nm, 250nm, and 400nm worth of Ag were deposited on the surface of the transparent structure layer of fine protrusions and recesses 22, were also produced. Here, the vapor deposited film thickness is measured by preparing glass substrates for measuring thickness separately from the samples, masking a portion of the surface of each glass substrate for measuring thickness, performing vapor deposition by placing the glass substrates for measuring thickness in a vapor deposition chamber with the substrates of the samples, removing the tape from the glass substrates for measuring thickness following vapor deposition, then measuring the thickness from surfaces where the tape is peeled off, on which metal has not been vapor deposited, to the surface of the vapor deposited metal.

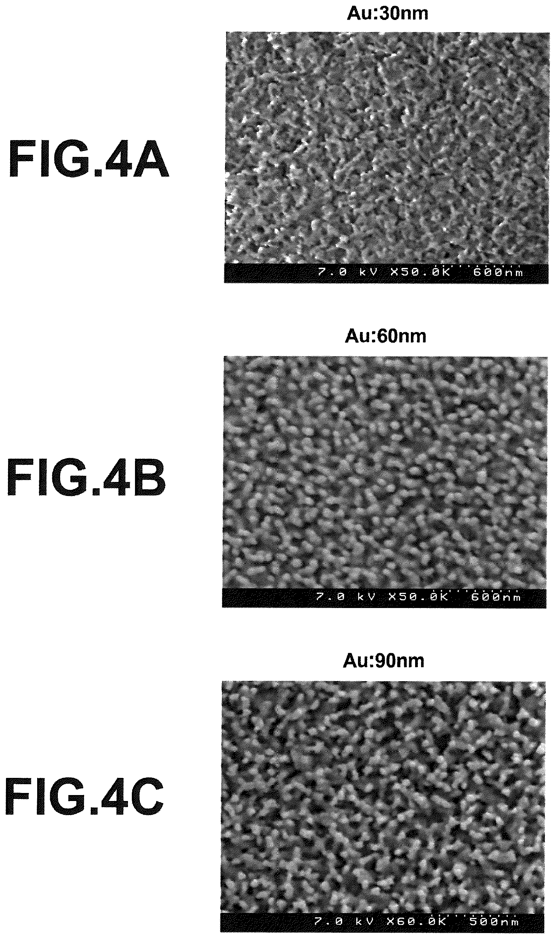

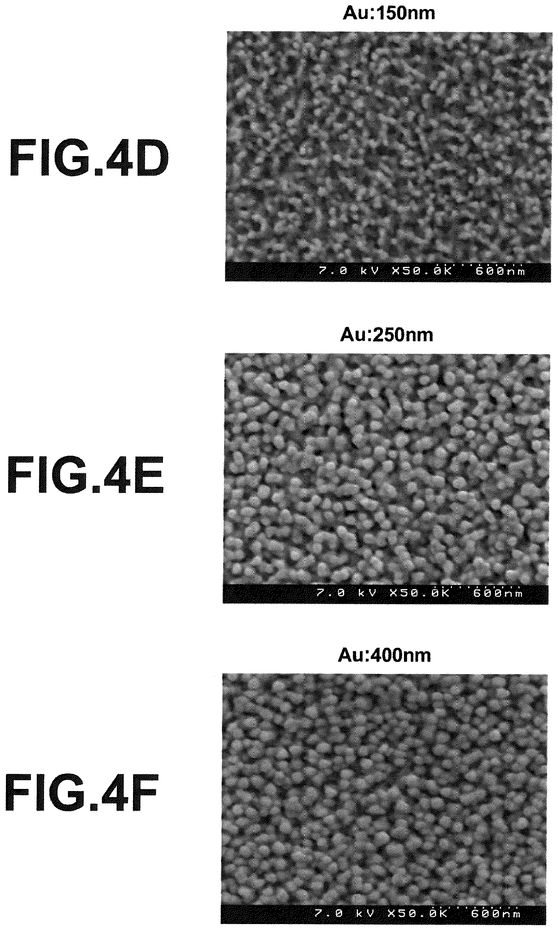

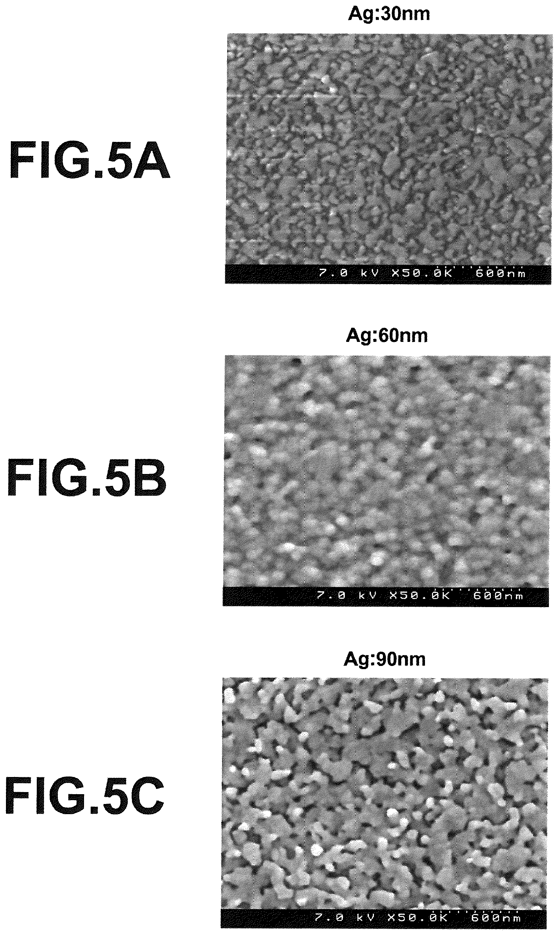

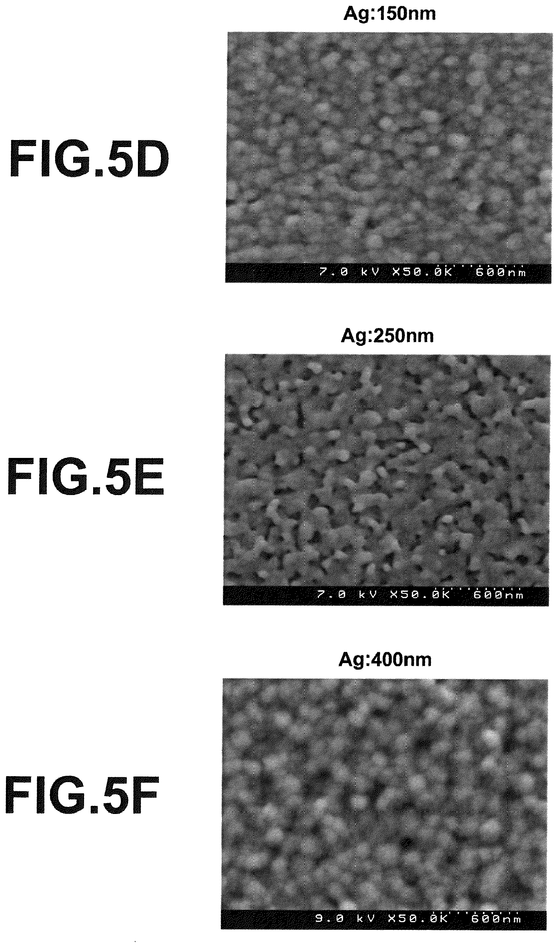

SEM images of the surface of each sample on which Au was vapor deposited are illustrated in Figures 4A through 4F, and SEM images of the surface of each sample on which Ag was vapor deposited are illustrated in Figures 5A through 5F.

In the case of Au vapor deposition, as the thickness of the gold formed by vapor deposition increases, the protrusions agglomerate and become granulated to form granular metal structures of fine protrusions and recesses having shapes different from that of the structure of fine protrusions and recesses 25 on the surface of the bayerite or boehmite, as illustrated in Figures 4A through 4F. When light is irradiated onto these metal granular shapes, extremely intense optical electrical fields called "hot spots" are generated among the granules, which is preferable in optical electrical field enhancing substrates. The granules become larger as the film thickness becomes thicker. As can be seen in Figure 4F, the granular shapes are maintained even at a film thickness of 400nm.

In the case of Ag vapor deposition, as the thickness of the silver formed by vapor deposition increases, the silver gradually at thicknesses from 30nm through 90nm to from island structures as illustrated in Figures 5A through 5C, and it is considered that the silver film layer gradually becomes flat. As illustrated in Figures 5D through 5F, the silver forms larger granular structures within thicknesses from 150nm through 400nm.

### (Measurement of Raman Scattered Light)

100µl of an ethanol solution in which rhodamine 6G was dissolved was spotted onto each sample of the optical electrical field enhancing substrate produced by the method described above. The solution was allowed to dry, and the dried samples were employed to measure Raman scattered light.

Raman scattered light was detected employing a microscopic Raman spectroscope (HR800). A laser beam having a peak wavelength of 785nm was employed as the excitation light beam, and observation was performed at a magnification of 20x. The laser power was 0.5mW immediately after an objective lens, and the irradiation time was 10 seconds.

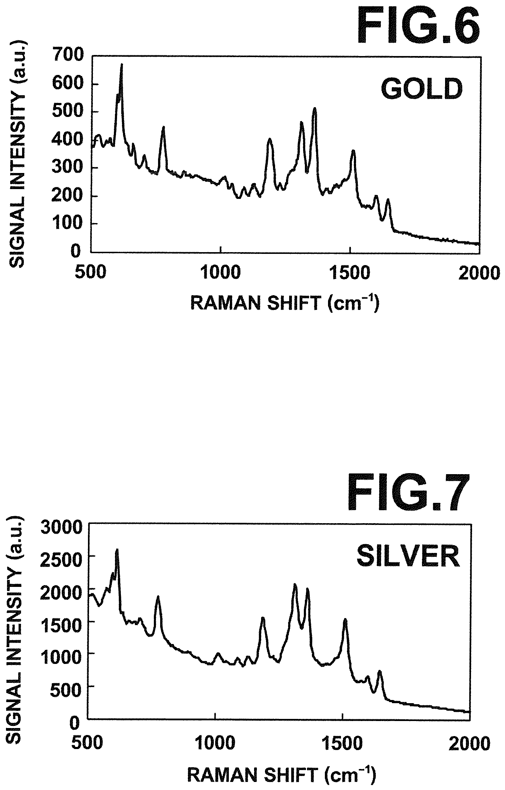

Figure 6 and Figure 7 are graphs that illustrate Raman shift spectrum distributions detected by the microscopic Raman spectroscope. Figure 6 illustrates the Raman spectrum obtained for a sample onto which 60µm of Au was vapor deposited, and Figure 7 illustrates the Raman spectrum obtained for a sample onto which 60µm of Ag was vapor deposited.

The samples produced by the method for producing an optical electrical field enhancing substrate, for which the Raman spectrum distributions are illustrated in Figures 6 and 7, enabled obtainment of extremely intense Raman signals. Note that more intense Raman signals were obtained from samples having thinner vapor deposited film thicknesses (30nm and 60nm) when silver was employed as the second metal compared to cases in which gold was employed as the second metal.

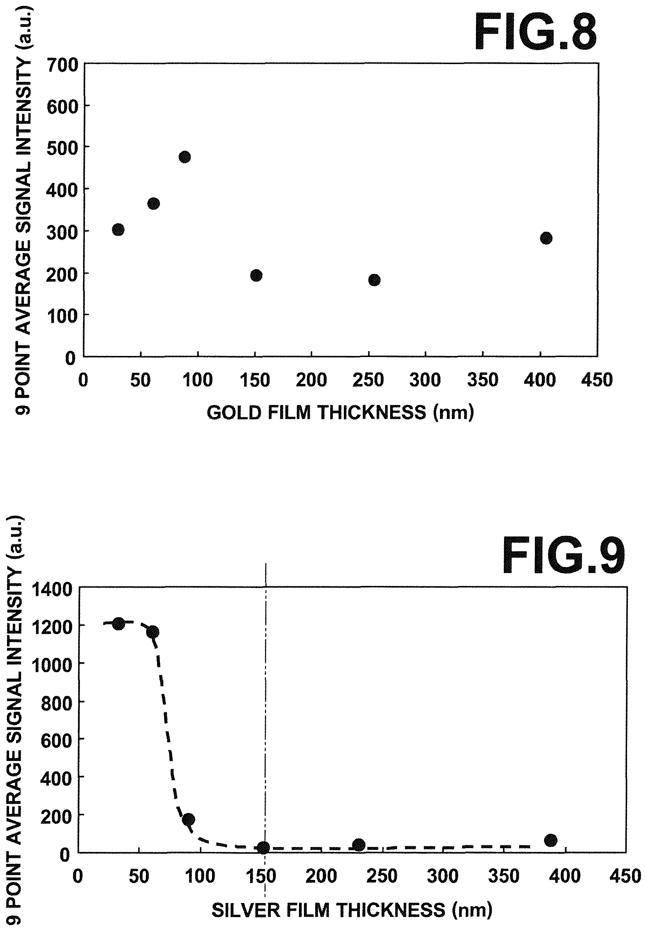

Figure 8 is a graph that plots peak intensities of 1360cm⁻¹ after removing white noise against Au vapor deposited film thickness as the horizontal axis, using Raman shift spectrum distributions obtained by detecting Raman scattered light at the front surfaces of the substrates for each of the samples on which Au was vapor deposited.

As illustrated in Figure 8, greater signal intensities were obtained as the Au vapor deposited film thickness became greater within a range of gold film thicknesses from 30nm through 90nm. As the vapor deposited film thickness of Au becomes thicker, Au forms granular shapes and the distances among protrusions become smaller to form a great number of hot spots as is clear from the SEM images of Figure 4A through Figure 4C. These are considered to be the reasons for the increase in signal intensity. Meanwhile, as illustrated in Figure 8, at gold film thicknesses from 150nm through 400nm, signal intensities are lower than those obtained at gold film thicknesses from 30nm through 90nm. The reason for the decrease in signal intensities is considered to be because the degree of optical electrical field enhancement deteriorates because the granule sizes increase, the granules contact each other, and become electrically continuous with each other. The signal intensity is greatest at the film thickness of 90nm. However, sufficient optical electrical enhancing effects are obtained at film thicknesses from 150nm through 400nm, and amplified Raman signals are detected.

Figure 9 is a graph that plots peak intensities of 1360cm⁻¹ after removing white noise against Ag vapor deposited film thickness as the horizontal axis, using Raman shift spectrum distributions obtained by detecting Raman scattered light at the front surfaces of the substrates for each of the samples on which Ag was vapor deposited.

It can be understood that signal intensities decrease drastically when the film thickness becomes 150nm or greater and that substantially no signals are obtained in the case of silver. The reason for the decrease in signal intensities is considered to be because the degree of optical electrical field enhancement deteriorates because the granule sizes increase, the granules contact each other, and become electrically continuous with each other, as in the case of gold. Further, the silver layer gradually becomes flat while the film thickness is relatively thin, then silver is further accumulated on the flattened silver layer. Therefore, it is considered that the silver layer readily becomes electrically continuous, resulting in the significant degrease in the optical electrical field intensity.

## Claims

1. A method for producing an optical electrical field enhancing device (1) comprising:
forming a thin film (20) from aluminium or alumina on a substrate (11);
forming a structure layer (22) of fine protrusions and recesses having an average pitch and an average depth which are less than the wavelength of excitation light from bayerite and/or boehmite by causing the thin aluminium or alumina film (20) to undergo a hydrothermal reaction, the pitch being the distance among the peaks of adjacent protrusions having recesses therebetween, and the depth being the distance from the peaks of the protrusions to the bottoms of the recesses adjacent thereto;
forming a metal structure layer (24) of fine protrusions and recesses constituted by a second metal on the surface of the structure layer (22) of fine protrusions and recesses by vapour deposition, the second metal being capable of generating localized plasmon when irradiated with excitation light,
the metal structure layer (24) being such that at least one of the height of the protrusions in the direction perpendicular to the substrate (11) and the length of the protrusions in the direction parallel to the substrate (11) is less than the wavelength of excitation light; and
laminating either a dielectric or a third metal different from the second metal on the metal structure layer (24).

2. A method according to Claim 1, wherein the metal structure layer (24) has a different shape from the structure layer (22).

3. A method according to Claim 1 or Claim 2, wherein the second metal is gold, silver, copper, aluminium or platinum.

4. A method according to Claim 3, wherein the second metal is gold, and the thickness of the film formed by vapor deposition is 30nm or greater.

5. A method according to Claim 3, wherein the second metal is silver, and the thickness of the film formed by vapor deposition is 150nm or less.

## Patentansprüche

1. Verfahren zur Herstellung einer Vorrichtung zur Verstärkung eines optisch-elektrischen Felds, umfassend:
Bilden eines dünnen Films (20) aus Aluminium oder Aluminiumoxid auf einem Substrat (11);
Bilden einer Strukturschicht (22) mit feinen Vorstößen und Vertiefungen mit einem mittleren Abstand und einer mittleren Tiefe, die kleiner sind als die Wellenlänge des Anregungslichts, aus Bayerit und/oder Boehmit, indem verursacht wird, daß der dünne Aluminium- oder Aluminiumoxid-Film (20) eine hydrothermale Reaktion eingeht, wobei der Abstand die Strecke zwischen den Spitzen von benachbarten Vorstößen mit Vertiefungen zwischen ihnen bezeichnet und die Tiefe die Strecke von den Spitzen der Vorstöße bis zu den Böden der Vertiefungen, die hierin angrenzen, ist;
Bilden einer Metallstrukturschicht (24) mit feinen Vorstößen und Vertiefungen, die aus einem zweiten Metall aufgebaut ist, auf der Oberfläche der Strukturschicht (22) mit feinen Vorstößen und Vertiefungen durch Dampfabscheidung, wobei das zweite Metall in der Lage ist, ein lokalisiertes Plasmon zu generieren, wenn mit Anregungslicht bestrahlt wird,
wobei die Metallstrukturschicht (24) so ist, daß zumindest eines von der Höhe der Vorstöße in der Richtung rechtwinklig zum Substrat (11) und der Länge der Vorstöße in der Richtung parallel zum Substrat (11) kleiner ist als die Wellenlänge des Anregungslichts; und
Laminieren von entweder einem Dielektrikum oder eines dritten Metalls, das sich von dem zweiten Metall unterscheidet, auf die Metallstrukturschicht (24).

2. Verfahren gemäß Anspruch 1, worin die Metallstrukturschicht (24) eine von der Strukturschicht (22) verschiedene Form aufweist.

3. Verfahren gemäß Anspruch 1 oder Anspruch 2, worin das zweite Metall Gold, Silber, Kupfer, Aluminium oder Platin ist.

4. Verfahren gemäß Anspruch 3, worin das zweite Metall Gold ist und die Dicke des durch Dampfabscheidung gebildeten Films 30 nm oder größer beträgt.

5. Verfahren gemäß Anspruch 3, worin das zweite Metall Silber ist und die Dicke des durch Dampfabscheidung gebildeten Films 150 nm oder kleiner ist.

## Revendications

1. Procédé de fabrication d'un dispositif d'amélioration de champ optoélectrique (1) comprenant :
la formation d'un film fin (20) à partir d'aluminium ou d'alumine sur un substrat (11) ;
la formation d'une couche de structure (22) de saillies et évidements fins ayant un pas moyen et une profondeur moyenne qui sont inférieurs à la longueur d'onde de lumière d'excitation provenant de la bayerite et/ou de la boehmite en faisant subir au film fin d'aluminium ou d'alumine (20) une réaction hydrothermique, le pas étant la distance entre les pics de saillies adjacentes ayant des évidements entre elles, et la profondeur étant la distance depuis les pics des saillies jusqu'aux bas des évidements adjacents à celles-ci ;
la formation d'une couche de structure métallique (24) de saillies et évidements fins constituée par un deuxième métal sur la surface de la couche de structure (22) de saillies et évidements fins par dépôt en phase vapeur, le deuxième métal étant capable de générer un plasmon localisé lorsqu'il est irradié par de la lumière d'excitation,
la couche de structure métallique (24) étant telle qu'au moins une de la hauteur des saillies dans la direction perpendiculaire au substrat (11) et la longueur des saillies dans la direction parallèle au substrat (11) est inférieure à la longueur d'onde de lumière d'excitation ; et
la stratification d'un métal diélectrique ou d'un troisième métal différent du deuxième métal sur la couche de structure métallique (24).

2. Procédé selon la revendication 1, dans lequel la couche de structure métallique (24) a une forme différente de la couche de structure (22).

3. Procédé selon la revendication 1 ou 2, dans lequel le deuxième métal est de l'or, de l'argent, du cuivre, de l'aluminium ou du platine.

4. Procédé selon la revendication 3, dans lequel le deuxième métal est de l'or, et l'épaisseur du film formé par dépôt en phase vapeur est de 30 nm ou plus.

5. Procédé selon la revendication 3, dans lequel le deuxième métal est de l'argent, et l'épaisseur du film formé par dépôt en phase vapeur est de 150 nm ou moins.
